Europäisches Patentamt

European Patent Office

Office européen des brevets

(19)

(11) EP 0 463 599 B1

(12) FASCICULE DE BREVET EUROPEEN

(45) Date de publication et mention
de la délivrance du brevet:
**31.01.1996 Bulletin 1996/05**

(51) Int Cl.⁶: **G01R 31/02**, G01B 13/12,
G01R 29/08

(21) Numéro de dépôt: **91110394.3**

(22) Date de dépôt: **24.06.1991**

(54) **Dispositif de détection d'intrusion sur une liaison comportant un câble**

Gerät zum Nachweis des Eingriffes in eine Kabelverbindung

Apparatus to detect intrusion on a cable link

(84) Etats contractants désignés:
**DE ES FR GB IT NL**

(30) Priorité: **27.06.1990 FR 9008107**

(43) Date de publication de la demande:
**02.01.1992 Bulletin 1992/01**

(73) Titulaire: **ALCATEL CABLE**
**F-92111 Clichy Cédex (FR)**

(72) Inventeur: **Boby, Joel**
**F-93370 Montfermeil (FR)**

(74) Mandataire: **Weinmiller, Jürgen et al**
**D-82336 Feldafing (DE)**

(56) Documents cités:
EP-A- 0 082 820    US-A- 4 040 044
US-A- 4 301 399

- **ELEKTROTECHNISCHE ZEITSCHRIFT, vol. 99,
no. 6, juin 1978, pages 356-358; E. JÄCKLE:
"Feststellung und Ortung von Mantelfehlern
bei Mittelspannungskabeln"**

## Description

L'invention concerne un dispositif de détection d'intrusion sur une liaison comportant un câble, ce câble pouvant être constitué de conducteurs métalliques ou de fibres optiques.

Pour protéger la confidentialité des informations transmises par une liaison, il est nécessaire de détecter toute tentative d'intrusion sur cette liaison; de retarder la réussite d'une telle tentative; et d'intervenir rapidement sur les lieux de cette tentative pour y remédier. Dans un premier temps, la détection d'une intrusion peut commander une interruption automatique de la liaison et l'utilisation d'une liaison de secours. Dans un second temps, une intervention sur les lieux de l'intrusion, permet de supprimer cette intrusion.

Une intrusion est réalisée en deux étapes : ôter les protections mécaniques qui recouvrent les conducteurs ou les fibres optiques portant des signaux; puis intercepter ces signaux par prélèvement d'une fraction de leur énergie. Il est souhaitable de détecter une intrusion dès la première étape, pour pouvoir intervenir sur les lieux avant même qu'il y ait eu interception des signaux.

Dans le cas d'une liaison par un câble à fibres optiques, il est envisageable de détecter une intrusion en superposant, au signal optique transportant des informations confidentielles, un autre signal optique ayant une longueur d'onde différente et un niveau bien défini, et en surveillant le niveau de ce signal après sa transmission, pour détecter toute atténuation apparaissant subitement et pouvant traduire une intrusion. Ce procédé nécessite un dispositif complexe pour superposer un signal optique à une extrémité de chaque fibre optique; prélever ce signal à l'autre extrémité de cette fibre; et mesurer son niveau.

Dans le cas d'une liaison par un câble comportant des conducteurs métalliques, il est envisageable de détecter une intrusion en détectant une modification de l'impédance des conducteurs, en un point, par un procédé de réflectométrie. Cependant un tel procédé n'est pas utilisable pour une grande longeur de câble, telle que 10 km.

Ces deux procédés ont pour inconvénient de détecter tardivement une intrusion, puisqu'ils ne détectent une intrusion que lorsqu'elle a effectivement réussie. Le but de l'invention est de détecter une tentative d'intrusion au moment où elle consiste à ôter les protections mécaniques du câble afin de pouvoir intervenir sur le lieu de l'intrusion avant même que des signaux aient été interceptés. D'autre part, une détection d'intrusion doit être efficace même si l'intrusion est réalisée au moyen d'outils en matériaux diélectriques, par exemple en céramique. Enfin, le dispositif de détection doit permettre de protéger un câble de grande longueur.

L'objet de l'invention est un dispositif tel qu'une détérioration des protections mécaniques du câble provoque un phénomène de claquage dans un diélectrique; claquage qui est détecté par le passage d'un courant électrique de claquage, à travers ce diélectrique.

Selon l'invention, un dispositif de détection d'intrusion sur une liaison comportant un câble, est caractérisé en ce que qu'il comporte :

- un premier cylindre conducteur entourant le câble;
- un cylindre isolant entourant le premier cylindre conducteur;
- un second cylindre conducteur entourant le cylindre isolant;
- des moyens pour détecter un abaissement de la tension de claquage du cylindre isolant, et fournir un signal d'alarme.

Selon un premier mode de réalisation, le cylindre isolant est constitué d'une couche cylindrique, continue, d'un diélectrique solide ayant une épaisseur constante. Ce diélectrique solide peut être plein, ou cellulaire à densité constante. Un diélectrique solide présente une rigidité diélectrique connue de manière relativement précise, ce qui facilite le choix de la tension du générateur.

Selon un autre mode de réalisation, le cylindre isolant comporte deux couches : une couche cylindrique, continue et homogène, d'un diélectrique solide, ayant une épaisseur constante; et une couche cylindrique d'un diélectrique gazeux, ayant une épaisseur constante, cette dernière couche étant superposée à la précédente. Comme pour le mode de réalisation précédent, le diélectrique solide peut être plein ou cellulaire à densité constante. Ce mode de réalisation présente un avantage, par rapport au précédent, pour les câbles de grande longueur, par exemple 10 km, car le courant de fuite à travers la couche de diélectrique solide est fortement réduit par la présence de la couche de diélectrique gazeux.

Ces deux modes de réalisation permettent de détecter une intrusion consistant à entamer la couche de diélectrique solide, même si l'intrusion est réalisée au moyen d'un outil en céramique. Le second mode de réalisation permet, en outre de détecter une intrusion dès le perçage du second cylindre conducteur, qui est le plus extérieur, si ce perçage est réalisé au moyen d'un outil métallique. En effet, cet outil métallique déclenche un claquage du matériau diélectrique gazeux avant même d'avoir touché la couche de diélectrique solide.

L'invention sera mieux comprise et d'autres caractéristiques apparaîtront à l'aide de la description ci-dessous d'un exemple de réalisation, et des figures l'accompagnant :

- la figure 1 représente schématiquement un exemple de réalisation du dispositif selon l'invention ;
- la figure 2 représente un premier câble coaxial comportant une couche de diélectrique homogène;
- la figure 3 représente le graphe du gradient de potentiel électrique à travers ce diélectrique homogène, pour une tension donnée appliquée aux deux conducteurs de ce premier câble coaxial;
- la figure 4 représente un second câble coaxial, comportant deux couches de diélectriques différents;

- la figure 5 représente le graphe du gradient de potentiel électrique dans ces deux couches de diélectriques, pour la même tension appliquée aux deux conducteurs de ce second câble coaxial.

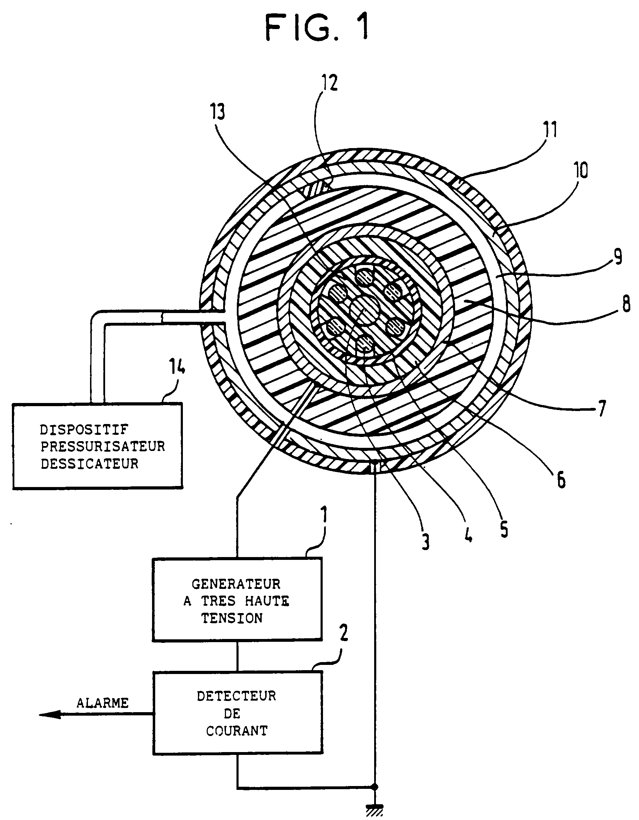

Sur la figure 1, l'exemple de réalisation comporte :

- un câble optique qui est constitué d'une âme 3, entourée de six fibres optiques 4 maintenues dans un profilé en matière plastique, 13, ce câble étant recouvert de deux couches de protection 5 et 6, en fibres de polyaramide et en poléthylène respectivement;
- un premier cylindre conducteur 7, entourant le câble optique et concentrique avec celui-ci;
- un cylindre isolant constitué d'une couche cylindrique 8, continue et homogène, en polyéthylène, ayant une épaisseur constante égale à 9 millimètres; et une couche d'air sec, 9, ayant une épaisseur constante égale à 1 millimètre, cette épaisseur étant définie par une entretoise 12 en polyéthylène, ayant une forme en hélice de telle sorte qu'elle n'occupe qu'une faible part du volume de la couche 9;
- un second cylindre conducteur 10, concentrique avec le câble, l'entretoise 12 étant placée entre le cylindre 10 et la couche de polyéthylène 8;
- une couche de protection mécanique 11 en polyéthylène;
- un générateur 1 à très haute tension et à haute impédance;
- un détecteur de courant, 2;
- et un dispositif pressurisateur et dessicateur, 14.

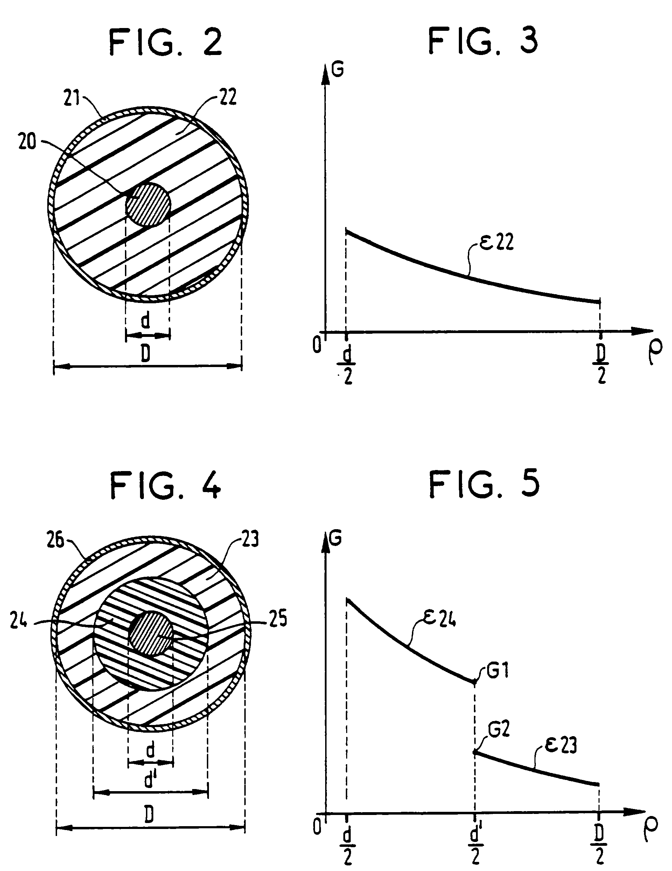

Les figures 2 à 5 illustrent la répartition du gradient de potentiel G dans deux câbles coaxiaux classiques, pour montrer la répartition du gradient de potentiel dans les couches diélectriques 8 et 9 de l'exemple représenté sur la figure 1. Le câble coaxial représenté en coupe sur la figure 2 comporte : un conducteur intérieur 20 ayant un diamètre $\underline{d}$; une couche de diélectrique 22, homogène, de permittivité $\varepsilon_{22}$; et un conducteur extérieur 21, de diamètre interne $\underline{D}$.

La figure 3 représente le graphe du gradient de potentiel G dans le diélectrique 22, en fonction de la distance $\rho$ par rapport à l'axe de symétrie du câble. Il est connu que ce graphe a la forme d'une portion d'hyperbole, conformément à la formule :

$$G = \frac{U}{\rho \cdot \text{Log} \frac{D}{d}}$$

où U est la différence de potentiel entre les deux conducteurs 20, 21.

Le gradient est maximal au voisinage du conducteur intérieur 20; puis il décroît rapidement pour les points plus éloignés.

Le câble coaxial représenté en coupe sur la figure 4 comporte : un conducteur intérieur 25 ayant un diamètre $\underline{d}$; une première couche de diélectrique homogène, 24, ayant un diamètre $\underline{d}'$ et une permittivité $\varepsilon_{24}$; une seconde couche de diélectrique homogène 23, ayant une permittivité $\varepsilon_{23}$; un conducteur extérieur 26 ayant un diamètre interne $\underline{D}$.

La figure 5 représente le graphe du gradient de potentiel G dans les diélectriques 23 et 24, en fonction de la distance par rapport à l'axe de symétrie du câble, pour une même tension U. Il est connu que ce graphe est constitué de deux portions d'hyperboles séparées par une discontinuité, à la jonction des deux couches de diélectriques, 23 et 24; à la distance

$$\frac{d'}{2}.$$

Le gradient G a une valeur G2 à l'intérieur de la couche 22, à proximité de la jonction, alors qu'il a une valeur :

$$G1 = G2 \cdot \frac{\varepsilon_{23}}{\varepsilon_{24}}$$

à l'intérieur de la couche 23 au voisinage de la jonction.

Dans l'exemple de réalisation représenté sur la figure 1, le gradient de potentiel, dans les couches 8 et 9 a une répartition analogue à celle représentée sur la figure 5. De préférence, la couche 8, de diélectrique solide, est choisie beaucoup plus épaisse que la couche 9, de diélectrique gazeux, afin que la zone de haut gradient, correspondant au gradient G2 sur la figure 5, soit proche du conducteur extérieur 10. Ainsi, il est possible d'obtenir un claquage, en cas d'intrusion, avec une tension U plus faible, appliquée entre les conducteurs 7 et 10.

Le générateur 1 et le détecteur de courant 2 permettent de susciter et de détecter un claquage des diélectriques situés entre le cylindre conducteur 7 et le cylindre conducteur 10 lors d'une tentative d'intrusion. Le cylindre conducteur 10 est relié à la terre, de même que l'une des bornes du détecteur 2. Une autre borne du détecteur 2 est reliée à une première borne du générateur 1. Une seconde borne du générateur 1 est reliée au cylindre conducteur 7. La polarité du générateur 1 est indifférente. Une borne de sortie du détecteur 2 produit un signal d'alarme lorsque l'intensité du courant circulant à travers le circuit constitué par : le générateur 1, le détecteur 2, et les couches isolantes 8 et 9, est supérieure à une valeur de seuil qui est choisie supérieure à l'intensité du courant de fuite en l'absence d'intrusion.

Le générateur 1 et le détecteur 2 sont de réalisation très classique. Ils peuvent être constitués par un dispositif de test utilisé classiquement pour tester l'isolement des conducteurs d'un câble. La tension du générateur 1 est choisie en faisant des essais. Elle doit être inférieure à la tension de claquage de l'ensemble des deux couches isolantes 8 et 9, et suffisante cependant pour qu'un claquage se déclenche si un outil métallique pénètre dans la couche d'air 9, et suffisante aussi pour déclencher un claquage de la couche de diélectrique solide 8, si un outil en matériau diélectrique entame celle-ci.

Si un outil diélectrique entame la couche 8, il abaisse localement la tension de claquage entre les conducteurs 7 et 10. En réglant la tension du générateur 1 à une valeur proche de la tension de claquage de l'ensemble des couches 8 et 9, il est possible de susciter un claquage dans un trou qui ne traverse pas totalement l'épaisseur de la couche de polyéthylène 8. A fortiori, le détecteur 2 peut détecter un court-circuit qui serait causé par la pénétration d'un outil métallique dans les deux cylindres conducteurs 7 et 10.

Le dispositif 14 est un dispositif utilisé classiquement pour pressuriser un câble coaxial comportant une couche diélectrique constituée d'air sec. Le dispositif 14 est relié à l'espace constituant la couche 9 par un orifice percé dans le cylindre conducteur 10 et dans la couche de protection 11. Le gaz utilisé pourrait être de l'azote, au lieu d'être de l'air sec.

Les conducteurs cylindriques 7 et 10 peuvent être constitués chacun d'une feuille de cuivre ou d'aluminium, soudée ou collée en forme de cylindre. Il est à remarquer que l'ensemble des pièces métalliques ou isolantes entourant le câble à fibres optiques peut être réalisé au moyen de machines classiques pour fabriquer des câbles coaxiaux comportant un diélectrique gazeux.

La portée de l'invention n'est pas limitée à cet exemple de réalisation. De nombreuses variantes sont à la portée de l'homme de l'art. Notamment, si la longueur du câble est suffisamment faible pour ne pas provoquer un courant de fuite rédhibitoire, il est possible d'utiliser un cylindre isolant comportant seulement la couche de diélectrique solide 8, la couche 9 étant supprimée. Il est possible d'utiliser des matériaux diélectriques classiques autres que le polyéthylène. En outre, le diélectrique solide peut être plein, ou cellulaire à densité constante. Il est possible de protéger un câble constitué de plusieurs conducteurs métalliques isolés, en le disposant à la place du câble optique, 3 à 6. Il est possible aussi de protéger un câble coaxial, son conducteur périphérique constituant alors le cylindre conducteur 7 et son conducteur central étant placé à la place du câble optique, 3 à 6.

**Revendications**

1. Dispositif de détection d'intrusion sur une liaison comportant un câble (3 à 6),
    caractérisé en ce que qu'il comporte :

    - un premier cylindre conducteur (7) entourant le câble (3 à 6);
    - un cylindre isolant (8,9) entourant le premier cylindre conducteur (7);
    - un second cylindre conducteur (10) entourant le cylindre isolant (8,9);
    - des moyens (1,2) pour détecter un abaissement de la tension de claquage du cylindre isolant (8, 9), et fournir un signal d'alarme.

2. Dispositif selon la revendication 1, caractérisé en ce que le cylindre isolant comporte une couche cylindrique (8), continue, de diélectrique solide, ayant une épaisseur constante.

3. Dispositif selon la revendication 2, caractérisé en ce que le cylindre isolant comporte, en outre, une couche cylindrique (9) de diélectrique gazeux, ayant une épaisseur constante définie par une entretoise de diélectrique solide (12) intercalée entre la couche de diélectrique solide (8) et le second cylindre conducteur (10).

4. Dispositif selon la revendication 1, caractérisé en ce que les moyens pour détecter un abaissement de la tension de claquage sont constitués d'un générateur de très haut tension continue (1), ayant une tension inférieure à la tension de claquage du cylindre isolant (8, 9); et d'un détecteur de courant (2) pour détecter un courant dû à un claquage.

5. Dispositif selon la revendication 4, caractérisé en ce que la tension du générateur (1) est telle qu'un claquage de la couche de diélectrique solide (8) se déclenche si celle-ci est entamée.

6. Dispositif selon la revendication 5, caractérisé en ce que la tension du générateur (1) est telle qu'un claquage de la couche de diélectrique solide (8) et de la couche de diélectrique gazeux (9) se déclenche si un outil métallique pénètre dans cette dernière.

**Patentansprüche**

1. Vorrichtung zur Erfassung eines Eindringens in eine ein Kabel (3 bis 6) enthaltende Leitung,
    dadurch gekennzeichnet, daß sie aufweist:

    - einen ersten, das Kabel (3 bis 6) umgebenden leitenden Zylinder (7),
    - einen isolierenden Zylinder (8, 9), der den ersten leitenden Zylinder (7) umgibt,
    - einen zweiten leitenden Zylinder (10), der den isolierende Zylinder (8, 9) umgibt,
    - Mittel (1, 2), um eine Absenkung der Durchschlagspannung des isolierenden Zylinders (8, 9) zu erfassen und ein Alarmsignal zu liefern.

2. Vorrichtung nach Anspruch 1, dadurch gekennzeichnet, daß der isolierende Zylinder eine durchgehende zylindrische Schicht (8) aus einem festen Dielektrikum mit einer konstanten Dicke enthält.

3. Vorrichtung nach Anspruch 2, dadurch gekennzeichnet, daß der isolierende Zylinder außerdem eine zylindrische Schicht (9) aus einem gasförmigen Dielektrikum mit einer konstanten Dicke aufweist, die von einem Abstandsstück aus festem Dielektrikum (12) definiert wird, das zwischen die Schicht aus festem Dielektrikum (8) und den zweiten leitenden Zylinder (10) eingefügt ist.

4. Vorrichtung nach Anspruch 1, dadurch gekennzeichnet, daß die Mittel zur Erfassung einer Absenkung der Durchschlagspannung aus einem Generator für hohe Gleichspannung (1), dessen Spannung unter der Durchschlagspannung des isolierenden Zylinders (8, 9) liegt, und aus einem Stromdetektor (2) bestehen, der einen auf einen Durchschlag zurückzuführenden Strom erfaßt.

5. Vorrichtung nach Anspruch 4, dadurch gekennzeichnet, daß die Spannung des Generators (1) so gewählt ist, daß ein Durchschlagen der Schicht aus festem Dielektrikum (8) ausgelöst wird, wenn sie beschädigt wird.

6. Vorrichtung nach Anspruch 5, dadurch gekennzeichnet, daß die Spannung des Generators (1) so gewählt ist, daß ein Durchschlagen der Schicht aus festem Dielektrikum (8) und der Schicht aus gasförmigem Dielektrikum (9) ausgelöst wird, wenn ein metallisches Werkzeug in das gasförmige Dielektrikum eindringt.

**Claims**

1. Device for detecting intrusion on a connection including a cable (3 to 6),
   characterised in that it includes:

   - a first conductive cylinder (7) around the cable (3 to 6);
   - an insulative cylinder (8, 9) around the first conductive cylinder (7);
   - a second conductive cylinder (10) around the insulative cylinder (8, 9);
   - means (1, 2) for detecting a reduction in the breakdown voltage of the insulative cylinder (8, 9) and producing an alarm signal.

2. Device according to claim 1 characterised in that the insulative cylinder includes an uninterrupted layer (8) of solid dielectric having a constant thickness.

3. Device according to claim 2 characterised in that the insulative cylinder further includes a cylindrical layer (9) of dielectric gas having a constant thickness defined by a solid dielectric spacer (12) disposed between the solid dielectric layer (8) and the second conductive cylinder (10).

4. Device according to claim 1 characterised in that the means for detecting a reduction in the breakdown voltage comprise a generator (1) producing a very high DC voltage less than the breakdown voltage of the insulative cylinder (8, 9) and a current detector (2) for detecting a current due to a breakdown.

5. Device according to claim 4 characterised in that the voltage of the generator (1) is such that a breakdown in the solid dielectric layer (8) occurs if the latter is cut into.

6. Device according to claim 5 characterised in that the voltage of the generator (1) is such that a breakdown occurs in the solid dielectric layer (8) and in the gas dielectric layer (9) if a metal tool penetrates the latter.

# FIG. 1

DISPOSITIF
PRESSURISATEUR
DESSICATEUR

GENERATEUR
A TRES HAUTE
TENSION

ALARME

DETECTEUR
DE
COURANT

# FIG. 2

# FIG. 3

# FIG. 4

# FIG. 5